(19)

Europäisches
Patentamt
European
Patent Office
Office européen
des brevets

(11) **EP 3 101 616 A1**

(12) **EUROPEAN PATENT APPLICATION**

(43) Date of publication:
**07.12.2016 Bulletin 2016/49**

(51) Int Cl.:
**G06Q 50/06** (2012.01)    **G06Q 10/04** (2012.01)
**G06Q 10/06** (2012.01)

(21) Application number: **15188821.1**

(22) Date of filing: **07.10.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **02.06.2015 GB 201509507**

(71) Applicant: **Passivsystems Limited
Newbury, Berkshire RG14 2PZ (GB)**

(72) Inventors:
• **Sweetnam, Trevor
London, Greater London SE16 4QR (GB)**
• **Harding, Fraser
Newbury, Berkshire RG14 1PS (GB)**
• **Carter, Edwin
Newbury, Berkshire RG20 7EH (GB)**
• **Crooks, Jim
Plymouth, Devon PL7 5JT (GB)**

(74) Representative: **Sharrock, Daniel John et al
Nash Matthews LLP
24 Hills Road
Cambridge CB2 1JP (GB)**

(54) **FAULT DETECTION IN ENERGY GENERATION ARRANGMENTS**

(57)    A fault detection system (12) for detecting abnormal energy generation data from an energy generation arrangement. The system comprises an electronic processing arrangement able to identify abnormal energy generation data from an energy generation arrangement and alert a user where analysis of the energy generated indicates that it is operating outside normal operation with reference to upper and/or lower thresholds. The thresholds are determined by the system with reference to a peer group of energy generation arrangements (10).

Fig. 1

**Description**

**Field of the invention**

The present invention relates to energy generation systems and more particularly to detection of abnormal or faulty operation of such systems.

**Background to the invention**

Entities invest in energy generation in order to generate a financial return from the sale of the energy produced. Many governments, including the United Kingdom, have further incentivised investment in generation of energy from renewable sources through additional payments for generation termed 'feed in tariffs' that are paid per unit of metered generation. The investor's returns completely rely on the output of the renewable generator and it is therefore it is vital for them to monitor its performance over the lifetime of the investment and ensure any issues are rectified quickly to avoid financial underperformance or losses.

The performance of a generator varies due to random effects and systematic effects. Investors are interested in some of the systematic differences in performance; those due to system faults or recurring problems such as shading, but not those simply due to miscalculation of expected yield (for example).

The prevailing weather conditions over any period is the primary influence on the output of many renewable generators; wind speed dictates the output of wind turbines, solar irradiation the output of photovoltaic panels and so on. Design output estimates, such as those used in investment models, rely on climatic norms to estimate 'typical' output over the lifetime of the generator.

Traditional approaches used to evaluate generator performance generally focus on correcting the output estimates for the difference between the climatic norm and the actual weather over a period as measured by a local weather station, a measurement instrument at the generator site or by calculating the theoretical output under the actual weather conditions for a period and comparing this to the metered generation.

The "Performance Ratio" for solar photovoltaic systems (see Dierauf et al (2013,) "Weather-Corrected Performance Ratio" available at www.nrel.gov/docs/fy13osti/57991.pdf), for example, is equal to:

$$\text{Actual generator output (kWh) / Nominal generator output (kWh)}$$

where actual generator output is the metered output of the generator and nominal generator output is:

$$\text{Incident solar radiation on the surface of the panel (kWh) x System conversion efficiency (\%)}$$

While the equations are simple the process of gathering and calculating the incident solar radiation and efficiency of the panels where they are sited at many different locations is expensive, complex and subject to considerable noise (see Taylor (2015), "Performance Ratio as a Tool for Fault Detection in PV Systems"). It is prohibitively expensive to install and maintain meteorological measurement equipment that can accurately measure independently the solar irradiation received on the surface of the panel. Therefore information gathered remotely, at a weather station or modelled using satellite imagery is commonly used. This method has a number of issues:

- The nearest measurement site may be many kilometres away from the generator location and therefore weather conditions between the two locations may vary significantly introducing error into the calculation.

- Solar irradiation is typically measured on a single horizontal plane. However, the generator is unlikely to have the same orientation as the measurement instrument and therefore a calculation must be carried out to estimate the solar irradiation received on the plane of the panel. These calculations are complex and rely on a number of simplifying assumptions. Therefore they introduce further error into the calculation process.

Renewable generator efficiencies can vary as a result of weather conditions, the materials used, the particulars of their installation and other factors. Therefore, in order to accurately calculate the theoretical system conversion efficiency a large amount of information regarding the characteristics of the system is required. This information is often difficult to ascertain and the calculations to estimate conversion efficiency are also subject to error.

In summary, traditional approaches, such as the Performance Ratio, require a significant amount of information that is difficult to obtain, prone to error and must be processed using calculations that add further uncertainty. The resulting performance measures are therefore too unreliable to be used for the identification of short term performance issues.

There are some existing systems that utilise a peer comparison approach to evaluate the performance of renewable generators. A paper by Leloux et al (Leloux, J., Narvarte, L., Luna, A., and Desportes, A. 2014, "Automatic Fault Detection on BIPV Systems Without Solar Irradiation Data" in 29th European Photovoltaic Solar Energy Conference and Exhibition, September 2014, Amsterdam) describes a fault detection procedure for solar photovoltaic generation units based on a performance indicator calculated using the energy production data of the units. The performance indicator is constructed by comparing the energy produced by a photovoltaic unit and the energy produced by a peer group of units having similar normalised energy outputs. Abnormal variation in the performance indicator for a unit may suggest the presence of a fault.

**Summary of the invention**

The present invention provides a fault detection system for detecting abnormal energy generation data from a first energy generating arrangement, the system comprising an electronic processing arrangement having:

at least one input for receiving energy generation data relating to the amount of energy generated by the first energy generating arrangement over a period of time, and for receiving energy generation data relating to the respective amounts of energy generated over the same period of time by a peer group of energy generating arrangements;
an output for outputting an alarm signal indicating abnormal energy generation data from the first energy generating arrangement; and
an alarm generating arrangement communicatively coupled to the output for alerting a user to abnormal energy generation data from the first energy generating arrangement in response to the alarm signal,

wherein the processing arrangement is configured to:

determine upper and/or lower alarm thresholds with reference to the respective amounts of energy generated by the energy generating arrangements of the peer group over the period of time;
determine an output parameter equal to or dependent on the amount of energy generated by the first energy generating arrangement over the period of time and compare the output parameter with the upper and/or lower alarm thresholds; and
generate an alarm signal at the output of the electronic processing arrangement if the output parameter for the first energy generating arrangement over the period of time exceeds the upper alarm threshold or is below the lower alarm threshold.

The system is preferably able to identify abnormal energy generation data from an energy generator and alert a user where analysis of the energy generated by the generator indicates that it is operating outside a normal operation band between upper and lower thresholds, with the band being determined by the system with reference to a peer group of generators.

The approach described in the Leloux paper has a number of limitations which embodiments of the present system seek to address:

1. Sufficient generation data must be available in order to carry out the correlation calculation and identify peers. Therefore it is not possible to detect issues with new installations. Preferred embodiments of the present system do not select peers with reference to past energy generation data and so performance analysis can begin almost immediately after installation.

2. Peers with similar panel orientations must be available. Embodiments of the present system may use readily available design specification output data (such as design expected output) to remove the need to find peers with similar panel orientations.

3. Where a generator has performed poorly since installation unsuitable peers might be chosen and an issue would not be identified. By utilising design expected output data, embodiments of the present system can identify this type of issue.

Embodiments of the present system compare the performance of an energy generation arrangement with a peer group to automatically identify abnormal performance, for instance poorly performing systems in need of maintenance.

They may be applicable to any energy system (including in particular solar PV and renewable generation) where:

- there is an interest in whether a specified level of performance has been reached;
- measured performance values vary for random or systematic reasons;
- there is a set of peers who are providing generation measurements and have available design expected output data estimated annual generation that takes into account system characteristics and may be adjusted for typical weather patterns.

Embodiments of the system described herein have the following advantages over the prior art:

- Peers may be identified using readily available information with no reference to historical generation time series. Therefore performance issues can be identified in newly installed generators.

- A comparison between a generator and its peers may be carried out using design expected output data that allows for the varying characteristics of generators, their orientation, peak output and so on that will be available from the design and installation process. Therefore a simpler peer selection process can be used.

- The identification of performance issues may be independent of weather conditions and therefore consistently identifies under-performing generators. It need not require expensive to acquire weather data as an input.

- The method may be robust with respect to natural and seasonal variation in performance of panels, and thereby avoid costly false alarms. It may avoid any need to tune alarm thresholds over the seasons, as the system may adjust its thresholds dynamically according to the performance levels of the peer group.

- The system can be incorporated within a comprehensive monitoring and verification system that includes a hierarchy of performance alarms. Automated triggering of maintenance requests may be provided, protecting investors' returns and driving consistent improvement in the performance of a portfolio of generators.

The peer group may be identified by user input. Alternatively, the system may select the peer group from a database of energy generating arrangements (stored within a storage module of the fault detection system or stored elsewhere) and accessed by the processing arrangement of the fault detection system.

Preferably, the at least one input of the processing arrangement is for receiving data relating to the geographical location of the first energy generating arrangement and for receiving data relating to the respective geographical locations of a plurality of other energy generating arrangements, and
the processing arrangement is configured to select the peer group of energy generating arrangements from the plurality of other energy generating arrangements with reference to their geographical location data and the geographical location data of the first energy generating arrangement.

The processing arrangement may be configured to select the peer group of energy generating arrangements from the plurality of other energy generating arrangements by selecting those of the plurality of other energy generating arrangements which are within a predetermined distance of the first energy generating arrangement with reference to their geographical location data and the geographical location data of the first energy generating arrangement.

In preferred embodiments, the processing arrangement is configured to select the peer group of energy generating arrangements from a plurality of other energy generating arrangements without reference to data relating to the energy actually generated by the first energy generating arrangement. In this way the peer group selection may not be influenced by abnormal energy generation data received from the outset from the generator being assessed.

The processing arrangement may be configured to select the peer group of energy generating arrangements from a or the plurality of other energy generating arrangements by a process which comprises selecting those of the plurality of other energy generating arrangements which meet at least one selection criterion relating to the performance specifications of the energy generating arrangements. The peer group selection may take into account the performance specifications of the energy generating arrangements (such as their design expected output or their maximum power output ratings, for example).

The processing arrangement may be configured to determine the upper and/or lower alarm thresholds with reference to respective amounts of energy actually generated by the peer group of energy generating arrangements over the period of time and respective estimates of the energy expected to be generated by the peer group of energy generating arrangements over the period of time, or another timespan, such as a year for example. The alarm threshold(s) may therefore be determined with reference to a normalised output parameter that takes into account the actual performance of the peer group generators relative to a theoretical or predicted performance level (such as their design expected output). The theoretical or predicted performance level may be calculated for the period of time concerned with reference to the time of year it covers and an estimate of the total annual generation amount for the respective generator.

The alarm thresholds may therefore be determined by the system having regard to the predicted performance of the generators of the peer group during the period of time under consideration (that is, the portion of a year or years covered by the period), to minimise the influence of seasonal variations in the output of the generators.

The output parameter for the first energy generating arrangement may be calculated by the processing arrangement with reference to the amount of energy generated by the first energy generating arrangement over the period of time and the estimate of the energy expected to be generated by the first energy generating arrangement.

The calculation used to determine the normalised output parameter for each of the peer group generators in determining the upper and/or lower alarm thresholds may also be carried out for the first energy generating arrangement. The result of the calculation for the first energy generating arrangement may then be compared with the upper and/or lower alarm thresholds to establish whether an alarm signal should be generated.

Calculation of the normalised output parameter for each generator may comprise dividing the actual energy generation of the generator over a period of time by an "expected output parameter", which may be its "design expected output". The design expected output may be related to (or equal to) the total expected annual energy output of the respective generator, for example where the generator being monitored and its peer group are expected to have a similar pattern of annual output. The design expected output is often a readily available parameter for a generator.

The expected output parameter may be derived by adjusting the design expected output with respect to the expected variation in the output during the period of time over which the comparison is to be made. This adjustment may be derived from information indicative of how the annual generation is expected to be distributed over the course of a year, by estimating how much of the expected annual generation is attributable to the period of the year concerned. An example of a known method for this derivation (the "PVGIS" system) is referred to below.

By comparing the performance of a generator with a peer group by reference to a normalised output parameter, the system may be used to monitor a diverse portfolio of generators. Preferably, the peer group is selected by reference to the geographical proximity of the generators to the monitored generator, to minimise the effect of weather variations between different geographical regions.

The upper and/or lower alarm thresholds may be determined with reference to upper and lower percentile values, respectively, of a set of performance related values calculated for the peer group of energy generating arrangements.

The upper and/or lower alarm thresholds may be calculated by multiplying the upper percentile value by an upper factor greater than 1 and by multiplying the lower percentile value by a lower factor less than 1, respectively. The upper and or lower factors may be predetermined. Alternatively, they may be set in response to user input to give a user control over the thresholds.

In preferred embodiments, the at least one input is for receiving energy generation data relating to the amount of energy generated by the first energy generating arrangement over a plurality of periods of time and for receiving energy generation data relating to the respective amounts of energy generated over the same periods of time by the plurality of other energy generating arrangements. This enables the system to analyse the data to detect trends in the performance data from a generator that develop over time.

For example, the processing arrangement may be configured to determine when the normalised output parameter of a generator over the plurality of periods of time is decreasing over time relative to the normalised output parameters of the peer group (or their median value or the lower alarm threshold) for each period. The processing arrangement may determine whether the position or ranking of a generator in its peer group on the basis of its normalised output is showing a falling trend over time. In response the processing arrangement may generate an alarm signal which indicates degrading performance.

In further embodiments, the processing arrangement may be configured to determine when the normalised output parameter of the first energy generating arrangement in the majority of or all of the plurality of periods of time is either above or below the upper or lower alarm threshold respectively and in response generate an alarm signal which indicates consistent over or under performance, respectively.

The first and other energy generating arrangements may be renewable energy generating arrangements of the same type or alternatively non-renewable energy generating arrangements of the same type. An example of a renewable type is solar powered energy generating arrangements, and another renewable type is wind powered generating arrangements.

The present invention further provides a method of detecting abnormal energy generation data from a first energy generating arrangement using an electronic processing arrangement, the method comprising:

receiving energy generation data relating to the amount of energy generated by the first energy generating arrangement over a period of time;

receiving energy generation data relating to the respective amounts of energy generated over the same period of time by a peer group of energy generating arrangements;

determining upper and/or lower alarm thresholds over the period of time with reference to the respective amounts of energy generated by the energy generating arrangements of the peer group over the period of time;

calculating an output parameter dependent on the amount of energy generated by the first energy generating arrangement over the period of time and comparing the output parameter with the upper and/or lower alarm thresholds;

generating an alarm signal if the output parameter for the first energy generating arrangement over the period of time exceeds the upper alarm threshold or is below the lower alarm threshold; and

alerting a user to abnormal operation of the first energy generating arrangement in response to the alarm signal.

In preferred embodiments, the method includes one or more further processing features described and/or claimed herein with reference to the fault detection system.

Brief description of the drawings

Embodiments of the invention will now be described by way of example and with reference to the accompanying schematic drawings, wherein:

Figure 1 is a block diagram showing a fault detection system according to an embodiment of the invention, in combination with a group of energy generating arrangements;
Figure 2 is a diagram illustrating a number of operating states for an energy generating arrangement monitored using a fault detection system embodying the present invention;
Figure 3 is a plot of the value of a normalised output performance parameter for a peer group of energy generating arrangements to illustrate a method embodying the present invention; and
Figure 4 is a plot similar to that of Figure 3, showing normalised output performance parameter values for several separate time periods.

Detailed description of the drawings

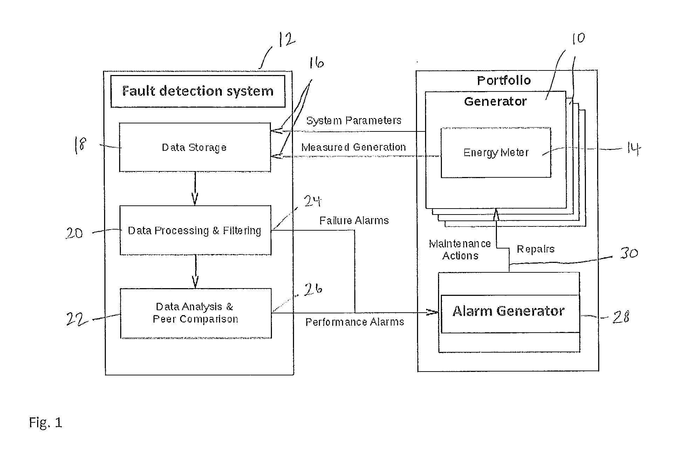

Figure 1 illustrates interaction between a plurality of energy generating arrangements and a fault detection system according to an embodiment of the invention. A plurality of generators 10 is communicatively coupled to a fault detection system 12.

Communication couplings referred to herein may be via wired or wireless networks, which may be private or via a shared network such as the internet.

The group of generators 10 may be an investor's portfolio or another set of generators. An energy meter 14 is associated with each generator and measures its actual energy output over time.

Data relating to the generators 10 is supplied to inputs 16 of the fault detection system 12. This data may comprise system parameters, for example design specification information relating to each generator such as its expected design output. This data may also include geographical location data identifying the geographical position of each generator. Data relating to the actual energy output of each generator may be supplied to the fault detection system from the respective energy meters 14.

Data inputted into the fault detection system is stored in a data storage module 18. This data is then available for processing by a data processing and filtering module 20. Module 20 may supply processed data to a data analysis and peer comparison module 22 for further processing.

Modules 20 and 22 have respective outputs 24 and 26 for outputting alarm signals indicating potentially abnormal performance of a generator 10. For example, module 20 may output alarm signals indicative of the failure of a generator, and module 22 may output alarm signals indicative of abnormal performance by a generator. Outputs 24 and 26 are communicatively coupled to an alarm generating arrangement 28. The alarm generating arrangement may be a display screen for example. In response to an alarm signal, the arrangement 28 may generate a user alert signal 30 indicating the need for assessment, maintenance and/or repair, for example, of an individual generator.

A fault detection system according to a preferred embodiment may be configured to carry out the following steps:

1. Receive details of the generator. At this point information relating to the generator's design expected output and geographic location may be updated into the system. This may be the only registration information required. It is preferable for the expected output parameter throughout the peer group to be calculated using a consistent methodology, for example using standard assumptions for typical weather.

2. Receive measured generator output from the monitored generator on an ongoing basis.

3. Check that the generator has reported some generation over the comparison period. If no generation has been reported raise a gross failure alarm and exclude from further analysis.

4. Identify suitable peers.

5. For each peer in the peer group divide actual output by design expected output to determine its normalised output parameter.

6. Sort the peers by their performance.

7. Identify the median performer and the 10th and 90th percentiles (for example).

8. Determine upper and lower alarm thresholds.

9. Check whether the normalised output parameter for the generator is below the lower alarm threshold. If so raise a performance alarm.

10. Check whether the normalised output parameter for the generator is above the upper alarm threshold. If so raise an incorrect data alarm.

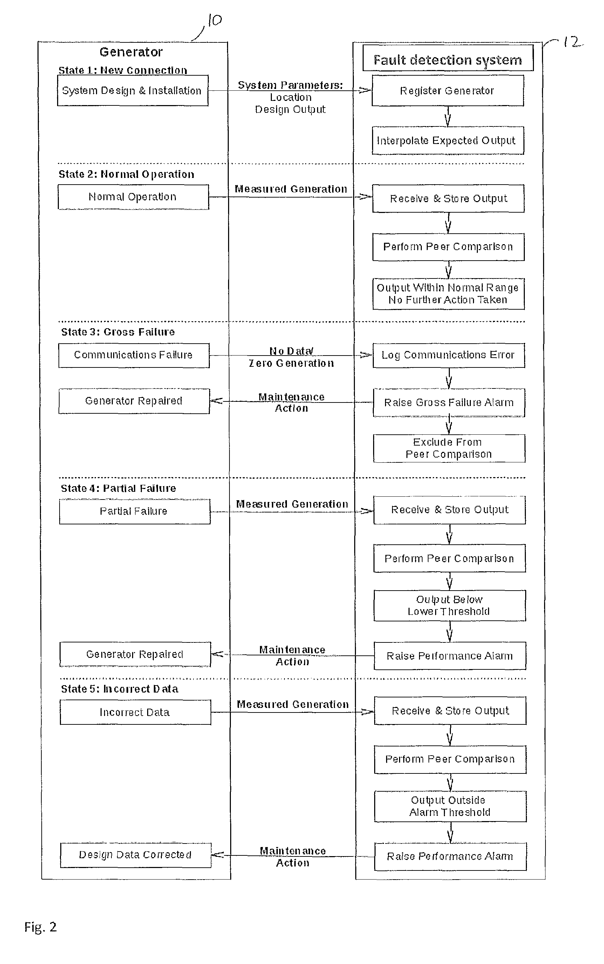

Figure 2 illustrates a number of examples generator states or scenarios for a monitored generator, and corresponding responses from a fault detection system embodying the invention.

A generator is in "State 1" upon connection to the fault detection system 12. As part of the installation process, system parameters specific to the generator are communicated to the fault detection system such as its geographical location and its expected design output rating. This data is stored by the fault detection system 12 in its data storage module 18. As discussed below with reference to the example of the "PVGIS" system, this data may be analysed or interpolated by the fault detection system to estimate the variation in the expected generation output against time over the course of a year.

In Figure 2, "State 2" denotes normal operation of the generator. Data relating to its design expected output is supplied to the fault detection system for storage. If its normalised output is to be found within a normal operating range for its peer group, no further action is taken by the fault detection system.

A generator is in "State 3" if a gross failure occurs. This may be detected by data processing and filtering module 20 of the fault detection system. This causes the system to generate an alarm signal and exclude the generator concerned from peer comparison analysis.

A generator is considered to be "State 4" if a partial failure or potentially abnormal failure takes place. This is detected by the fault detection system. This may be as a result of peer comparison carried out by module 22. This causes the fault detection system to generate an alarm signal flagging to the user the need for assessment of the generator concerned.

"State 5" designates a generator which has incorrect design specification data associated with it. This causes the fault detection system to generate a corresponding alarm signal, alerting the user to the need to review the data associated with the generator concerned.

The inputs to the fault detection system may comprise:

- System parameters: system type (solar PV, wind, for example), geographic location and design expected output (as calculated by the system designer for example).

- Measured generation: metered generation of the system over some predefined period (perhaps collected using an internet-connected electricity meter).

For a given generator over a given period the following data processing steps may be performed by a fault detection system embodying the invention:

- Interpolation: in order to provide analysis over a selected period the design expected output is interpolated in a manner that reflects the expected variation of the generator's output over a typical year. There are industry-standard methodologies for this calculation. In the case of Solar PV, the PVGIS system (see re.jrc.ec.europa.eu/pvgis) is capable of providing daily or monthly expected output. This calculation may be performed once, at system registration, and/or for any selected period.
This step may be eliminated by restricting a generator's peers to those with similar characteristics that are expected to have a similar pattern of annual output and dividing the output over any period by the design expected output.

- Data selection: select the measured and estimated generation for all generators of the peer group over the period of interest. The period of interest is typically the last month but can be defined by the user. A minimum volume of valid data for inclusion in the comparison may be defined which is sufficient to provide meaningful results.

- Data checking: generators with no available generation data (for example because of a communications fault) or that have reported zero generation (because of gross failure) are identified, error alarms are raised and these are removed from further analysis. This step is optional, but valuable in practice.

- Peer group identification: The peer group may be identified by user input. In other embodiments, a clustering approach is applied across all generators to identify a peer group or to divide the generators into a plurality of groups. This clustering (for a given generator type such as wind, solar or CHP for example) may be on the basis of one or more design specification parameters (such as expected design output) and/or geographic proximity. Clustering may be done by a hierarchical clustering algorithm with a predetermined maximum geographical radius for each group, for example. In further embodiments, the peer group may be an individual investor's portfolio of generators which may typically be geographically clustered and designed using a similar methodology.

The process of peer identification can be carried out each time a comparison is requested in order to identify the closest peers at that time, or carried out once at system registration. The former is useful where a portfolio is growing and better peers may continually become available. The latter saves computational time and also enables consistent treatment of generators on the edge of a group.

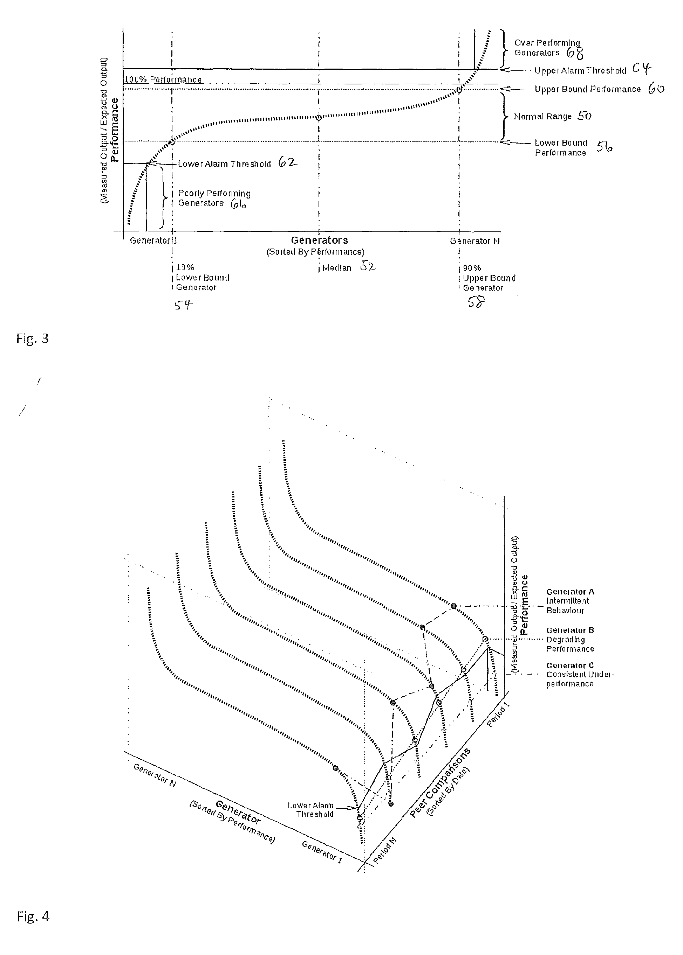

By comparing the performance of any individual generator to a selection of similar peers, as illustrated in Figure 3, without relying on measured weather data or conversion algorithms, it is possible to reliably identify poor performance over much shorter measurement periods. This is of great value to investors when used with a system providing constant monitoring, evaluation and verification, such as the one illustrated in Figure 1, as issues can be automatically identified and rectified rapidly, ensuring non-generation and consequent financial losses are minimised.

A minimum peer group size may be required in order to provide a reasonable analysis. A maximum group size may be identified in order to limit processing time.

Having pre-processed the data the following calculation and analysis steps are performed for the entire peer group:

- Calculate normalised output: for each generator, calculate the total measured generation and the total expected output parameter over the period. Divide the total measured generation by the expected output parameter to calculate the proportion of expected output generated.

- Sort generators: sort the generators within the peer group by their normalised output as calculated above. A plot of calculated normalised output for a group of generators ordered from lowest to highest performance is shown schematically in Figure 3.

- Define normal range 50: find the median performing generator 52 and the generators that fall within the normal range of performance. The lower bound of the normal range is defined by the performance 56 of the generator 54 at a configurable percentile value, the lower bound percentile. This may be selected or set to be the 10th percentile for example. Similarly, the upper bound of the normal range is determined by the performance 60 of the generator 58 at a configurable percentile value, the upper bound percentile. This may be selected or set to be the 90th percentile for example.
Defining a normal range from peer data means that natural variations in performance are accounted for (for example, there is a greater variation in incident solar generation in winter, so there will be a greater spread between the lower and upper bounds), avoiding unnecessary false alarms. Excluding extreme values ensures the method is robust to outliers.
The median performance of the peer group is unlikely to be 100%. Therefore the overall performance of the group as a whole may be easily evaluated with reference to the median performance. It may be displayed to an operator along with any alarms.

- Define upper and lower alarm thresholds: the lower alarm threshold 62 is a proportion of the lower bound performance 56, where the proportion is defined by a lower alarm threshold ratio (for example, 70% of the lower bound performance). The lower alarm threshold ratio may be configurable by the system user, allowing them to control the number of alarms received. Similarly, an upper alarm threshold 64 is a proportion of the performance above the upper bound performance 60, where the proportion is defined by the upper alarm threshold ratio (for example, 150% of the upper bound performance).

- Raise alarms: Generators 66 with performance below the lower alarm threshold 62 are flagged as poorly performing and in need of maintenance or repair. Generators 68 above the upper threshold are flagged as potentially having incorrect input data, for example, design annual generation may have been incorrectly inputted.

Having received the alarms, the user can take appropriate actions to rectify issues. The system is designed to be used as part of a process of constant monitoring and improvement, with a view to all generators within a portfolio lying within the normal operating range, maximising returns for investors. In those circumstances, embodiments of the present approach will not generate any alarms, unlike some existing peer comparison methods which will continue to flag the lowest performing systems as problematic.

Data describing the peer comparison for a series of periods, including position of each generator within its peer group, alarms raised and so on may be stored after each completed analysis. This data may be analysed to provide further valuable insights as illustrated by Figure 4. By storing the position or ranking of any generator within its peer group, additional analysis may be carried out using the historical record or data to allow fault classification. Figure 4 is an example of a graphical illustration of this process.

This approach may particularly be applied to generators falling below the lower performance threshold. Analysing the position of any generator or generators within this group allows:

- Intermittent behaviour to be identified where a generator passes above and below the threshold over a series (1 to N) of peer comparison periods (Generator A).

- Developing faults to be identified early where the symptom is a generator's performance compared to its peers consistently degrading (Generator B).

- Consistent under performance to be observed where a generator consistently lies near the bottom of the peer group (Generator C).

This further analysis of the comparison data that can, for example, allow an investor to develop further confidence as to the existence of a genuine fault before incurring the expense of a maintenance visit.

Although the embodiments of the invention described with reference to the drawings comprise processes performed by a processing arrangement, the invention also extends to computer programs comprising instructions for causing a processing arrangement or a computer to perform the processes. More particularly, computer programs on or in a carrier, adapted for putting the invention into practice are encompassed by the present disclosure. The program may be in the form of source code, object code, a code intermediate source and object code such as in partially compiled form, or in any other form suitable for use in the implementation of the processes according to the invention. The carrier may be any entity or device capable of carrying the program.

For example, the carrier may comprise a storage medium, such as a ROM, for example a CD ROM or a semiconductor ROM, or a magnetic recording medium, for example a floppy disc or hard disk. Further, the carrier may be a transmissible carrier such as an electrical or optical signal which may be conveyed via electrical or optical cable or by radio or other means.

When the program is embodied in a signal which may be conveyed directly by a cable or other device or means, the carrier may be constituted by such cable or other device or means.

Alternatively, the carrier may be an integrated circuit in which the program is embedded, the integrated circuit being adapted for performing, or for use in the performance of, the relevant processes.

Thus, the present invention provides a computer program comprising program instructions for causing a computer to perform the methods described herein. Furthermore it includes provision of such a computer program on a carrier, embodied in a record medium, stored in a computer electronic memory, embodied in a read-only electronic memory, or carried on an electrical carrier signal.

**Claims**

1. A fault detection system for detecting abnormal energy generation data from a first energy generating arrangement, the system comprising an electronic processing arrangement having:

at least one input for receiving energy generation data relating to the amount of energy generated by the first energy generating arrangement over a period of time, and for receiving energy generation data relating to the respective amounts of energy generated over the same period of time by a peer group of energy generating arrangements;

an output for outputting an alarm signal indicating abnormal energy generation data from the first energy generating arrangement; and

an alarm generating arrangement communicatively coupled to the output for alerting a user to abnormal energy generation data from the first energy generating arrangement in response to the alarm signal,

wherein the processing arrangement is configured to:

determine upper and/or lower alarm thresholds with reference to the respective amounts of energy generated by the energy generating arrangements of the peer group over the period of time;

determine an output parameter equal to or dependent on the amount of energy generated by the first energy generating arrangement over the period of time and compare the output parameter with the upper and/or lower alarm thresholds; and

generate an alarm signal at the output of the electronic processing arrangement if the output parameter for the first energy generating arrangement over the period of time exceeds the upper alarm threshold or is below the lower alarm threshold.

2. A system of claim 1, wherein the at least one input is for receiving data relating to the geographical location of the first energy generating arrangement and for receiving data relating to the respective geographical locations of a plurality of other energy generating arrangements, and

the processing arrangement is configured to select the peer group of energy generating arrangements from the plurality of other energy generating arrangements with reference to their geographical location data and the geographical location data of the first energy generating arrangement.

3. A system of claim 1 or claim 2, wherein the processing arrangement is configured to select the peer group of energy generating arrangements from a or the plurality of other energy generating arrangements without reference to data relating to energy generated by the first energy generating arrangement.

4. A system of claim 2 or claim 3 when dependent on claim 2, wherein the processing arrangement is configured to select the peer group of energy generating arrangements from the plurality of other energy generating arrangements by selecting those of the plurality of other energy generating arrangements which are within a predetermined distance of the first energy generating arrangement with reference to their geographical location data and the geographical location data of the first energy generating arrangement.

5. A system of any preceding claim, wherein the processing arrangement is configured to select the peer group of energy generating arrangements from a or the plurality of other energy generating arrangements by a process which comprises selecting those of the plurality of other energy generating arrangements which meet at least one selection criterion relating to the performance specifications of the energy generating arrangements.

6. A system of any preceding claim, wherein the at least one input is for receiving data relating to respective estimates of the energy expected to be generated by the first and the peer group of energy generating arrangements over a predetermined period of time, and

wherein the processing arrangement is configured to determine the upper and/or lower alarm thresholds with reference to the respective amounts of energy generated by the energy generating arrangements of the peer group over the period of time and the respective estimates of the energy expected to be generated by the energy generating arrangements of the peer group, and to calculate the output parameter for the first energy generating arrangement with reference to the amount of energy generated by the first energy generating arrangement over the period of time and the estimate of the energy expected to be generated by the first energy generating arrangement.

7. A system of any preceding claim, wherein the upper and/or lower alarm thresholds are determined with reference to upper and lower percentile values, respectively, of a set of performance related values for the peer group of energy generating arrangements.

8. A system of claim 7, wherein the upper and/or lower alarm thresholds are calculated by multiplying the upper percentile value by an upper factor greater than 1 and by multiplying the lower percentile value by a lower factor less than 1, respectively, and the upper and or lower factors are preferably set in response to user input.

9. A system of any preceding claim, wherein the at least one input is for receiving energy generation data relating to the amount of energy generated by the first energy generating arrangement over a plurality of periods of time and for receiving energy generation data relating to the respective amounts of energy generated over the same periods of time by the energy generating arrangements of the peer group.

10. A system of claim 9, wherein the processing arrangement is configured to determine when the ranking of a normalised output parameter calculated for the first energy generating arrangement over the plurality of periods of time is decreasing over time against the respective normalised output parameters calculated for the energy generating arrangements of the peer group over the plurality of periods of time and in response generate an alarm signal which indicates degrading performance.

11. A system of claim 9 or claim 10, wherein the processing arrangement is configured to determine when a normalised output parameter calculated for the first energy generating arrangement in each of the plurality of periods of time is either above or below the upper or lower alarm threshold respectively and in response generate an alarm signal which indicates consistent over or under performance, respectively.

12. A system of any preceding claim, wherein the first and other energy generating arrangements are renewable energy generating arrangements, and preferably the first and other energy generating arrangements are all solar or all wind powered energy generating arrangements.

13. A method of detecting abnormal energy generation data from a first energy generating arrangement, the method comprising:

receiving energy generation data in an electronic processing arrangement relating to the amount of energy generated by the first energy generating arrangement over a period of time;
receiving energy generation data in the electronic processing arrangement relating to the respective amounts of energy generated over the same period of time by a peer group of energy generating arrangements;
determining with the electronic processing arrangement upper and/or lower alarm thresholds over the period of time with reference to the respective amounts of energy generated by the energy generating arrangements of the peer group over the period of time;
calculating with the electronic processing arrangement an output parameter dependent on the amount of energy generated by the first energy generating arrangement over the period of time and comparing the output parameter with the upper and/or lower alarm thresholds;
generating an alarm signal with the electronic processing arrangement if the output parameter for the first energy generating arrangement over the period of time exceeds the upper alarm threshold or is below the lower alarm threshold; and
alerting a user to abnormal operation of the first energy generating arrangement with an alarm generating arrangement in response to the alarm signal.

14. A method of claim 13 using a system of any of claims 1 to 12.

15. A recording medium storing computer interpretable instructions for causing a programmable apparatus to become configured as the fault detection system of any of claims 1 to 12 or to cause a programmable apparatus to perform a method in accordance with claim 13 or claim 14, wherein the recording medium preferably comprises a computer disc which may be a magnetic, optical or magneto-optical disc, or the recording medium preferably comprises a signal in a communications network.

Fig. 1

10

12

**Generator**

**State 1: New Connection**

| System Design & Installation |

**State 2: Normal Operation**

| Normal Operation |

**State 3: Gross Failure**

| Communications Failure |

| Generator Repaired |

**State 4: Partial Failure**

| Partial Failure |

| Generator Repaired |

**State 5: Incorrect Data**

| Incorrect Data |

| Design Data Corrected |

**System Parameters:**
Location
Design Output

**Measured Generation**

**No Data/**
**Zero Generation**

**Maintenance**
**Action**

**Measured Generation**

**Maintenance**
**Action**

**Measured Generation**

**Maintenance**
**Action**

**Fault detection system**

| Register Generator |

| Interpolate Expected Output |

| Receive & Store Output |

| Perform Peer Comparison |

| Output Within Normal Range No Further Action Taken |

| Log Communications Error |

| Raise Gross Failure Alarm |

| Exclude From Peer Comparison |

| Receive & Store Output |

| Perform Peer Comparison |

| Output Below Lower Threshold |

| Raise Performance Alarm |

| Receive & Store Output |

| Perform Peer Comparison |

| Output Outside Alarm Threshold |

| Raise Performance Alarm |

Fig. 2

Fig. 3

Fig. 4

Europäisches
Patentamt

European
Patent Office

Office européen
des brevets

# EUROPEAN SEARCH REPORT

Application Number

EP 15 18 8821

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | Jonathan Leloux ET AL: "Automatic fault detection on BIPV systems without solar irradiation data", <br><br>, <br>25 October 2014 (2014-10-25), XP055233468, <br>DOI: 10.13140/2.1.2280.3200 <br>Retrieved from the Internet: <br>URL:http://arxiv.org/ftp/arxiv/papers/1410/1410.6946.pdf <br>[retrieved on 2015-12-03] <br>* the whole document * <br>----- | 1-15 | INV. <br>G06Q50/06 <br>G06Q10/04 <br>G06Q10/06 |

TECHNICAL FIELDS
SEARCHED       (IPC)

G06Q

The present search report has been drawn up for all claims

| Place of search | Date of completion of the search | Examiner |
|---|---|---|
| Munich | 8 December 2015 | Härdeman, David |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

......................................................................................................
& : member of the same patent family, corresponding
document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **DIERAUF et al.** *Weather-Corrected Performance Ratio,* 2013, www.nrel.gov/docs/fy13osti/57991.pdf
- **TAYLOR.** *Performance Ratio as a Tool for Fault Detection in PV Systems,* 2015

- **LELOUX, J. ; NARVARTE, L. ; LUNA, A. ; DESPORTES, A.** Automatic Fault Detection on BIPV Systems Without Solar Irradiation Data. *29th European Photovoltaic Solar Energy Conference and Exhibition,* September 2014